# EUROPÄISCHE PATENTSCHRIFT

(11) **EP 3 358 735 B1**
(45) Veröffentlichungstag und Bekanntmachung des Hinweises auf die Patenterteilung: **07.04.2021**
(21) Anmeldenummer: 18155057.5
(22) Anmeldetag: 05.02.2018
(51) Int. Cl.: H02M 7/00, H02M 7/537, H05K 5/00, H03K 17/56, H03K 17/687

(54) **SCHALTUNGSANORDNUNG FÜR EIN ELEKTRONISCHES GERÄT**
SWITCHING ARRAY FOR AN ELECTRONIC DEVICE
AGENCEMENT DE COMMUTATION POUR UN APPAREIL ÉLECTRONIQUE

(30) Priorität: 06.02.2017 DE 102017201817
(43) Veröffentlichungstag der Anmeldung: 08.08.2018
(73) Patentinhaber: AUDI AG, 85045 Ingolstadt (DE)
(72) Erfinder: Apelsmeier, Andreas, 85131 Pollenfeld (DE); Asam, Johann, 86559 Adelzhausen (DE)

(56) Entgegenhaltungen:
- DE-T5- 10 297 140

## Beschreibung

Die Erfindung betrifft eine Schaltungsanordnung für ein elektronisches Gerät.

Ein elektronisches Leistungsmodul kann bspw. als B6-Brücke oder als eine einzelne Halbbrücke ausgebildet sein. Dabei umfasst das Leistungsmodul in der Regel mehrere physikalisch parallel geschaltete Halbleiterbauelemente, z. B. IGBTs oder MOSFETs, mit denen ein jeweils erforderlicher Strom bereitgestellt wird. Dabei sind diese Halbleiterbauelemente vom selben Typ und bspw. als Silizium-IGBTs mit vorgeschalteten Silizium-Dioden ausgebildet. Alternativ kann zu einem Silizium-IGBT eine Silizium-Carbid-Diode parallel geschaltet sein. Die parallel geschalteten Halbleiterbauelemente sind jedoch immer vom selben Hersteller und gleichen Typ. Weiterhin wird bei dem Leistungsmodul versucht, den Strom möglichst symmetrisch über alle parallel geschalteten Halbleiterbauelemente zu verteilen. In der Regel ist dieses Leistungsmodul auf einen Kompromiss aus Durchlassverlusten und Schaltverlusten optimiert. Damit kann jedoch nur ein Punkt aus einer Trade-Off-Kennlinie verwendet werden, wobei eine Charakteristik des Leistungsmoduls auf einem Kompromiss einer Auslegung nur eines Typs von Halbleiterbauelementen basiert.

Ein Verfahren und eine Schaltung zur Reduktion von Verlusten in einem DC-DC-Wandler sind aus der Druckschrift DE 102 97 140 T5 bekannt. Die Schaltung umfasst einen Schalter mit ersten und zweiten Transistoren, die zwischen ersten und zweiten Anschlüssen parallel geschaltet sind, wobei der zweite Transistor in seiner Bauform größer als der erste Transistor ist.

Vor diesem Hintergrund war es eine Aufgabe, eine Charakteristik eines Leistungsmoduls anzupassen.

Diese Aufgabe wird mit einer Schaltungsanordnung mit den Merkmalen des unabhängigen Patentanspruchs 1 gelöst. Ausführungsformen der Schaltungsanordnung gehen aus den abhängigen Patentansprüchen und der Beschreibung hervor.

Die erfindungsgemäße elektronische Schaltungsanordnung, bspw. ein Leistungsmodul, ist für ein elektronisches Gerät vorgesehen und weist mindestens zwei zueinander parallel geschaltete bzw. angeordnete, gleichartige Halbleiterelemente bzw. Halbleiterbauteile auf, wobei mindestens ein erstes Halbleiterelement eine erste Charakteristik und mindestens ein zweites Halbleiterelement eine zweite Charakteristik aufweist, wobei jede der beiden Charakteristiken durch mindestens eine Verlustleistung definiert ist. Die mindestens eine Verlustleistung des mindestens einen ersten Halbleiterelements weist einen ersten Wert auf, wohingegen die mindestens eine Verlustleistung des mindestens einen zweiten Halbleiterelements einen zweiten Wert aufweist, wobei die beiden Werte der mindestens einen Verlustleistung unterschiedlich sind. Dabei weisen die mindestens zwei gleichartigen Halbleiterelemente dieselbe Kennlinie auf, wobei die mindestens zwei Halbleiterelemente an unterschiedlichen Punkten entlang dieser Kennlinie betrieben werden. Außerdem ist eine erste Verlustleistung als Durchlassverlust und eine zweite Verlustleistung als Schaltverlust ausgebildet bzw. definiert.

Die mindestens zwei zueinander parallel geschalteten Halbleiterelemente sind gleichartig ausgebildet, was in der Regel bedeutet, dass sie vom gleichen Typ, bspw. Halbleitertyp sind und/oder die gleiche schaltungstechnische Struktur bzw. Architektur aufweisen. Allerdings ist dennoch vorgesehen, dass sich diese mindestens zwei gleichartigen Halbleiterelemente hinsichtlich mindestens einer Charakteristik, üblicherweise der Verlustleistung und somit hinsichtlich mindestens einer physikalischen Eigenschaft, auch bei Vorliegen derselben Struktur bzw. Architektur der mindestens zwei Halbleiterelemente voneinander unterscheiden. Üblicherweise sind die beiden gleichartigen Halbleiterelemente entweder aktive oder passive Halbleiterelemente.

Demnach unterscheiden sich die mindestens zwei zueinander parallel geschalteten, gleichartigen Halbleiterelemente zumindest hinsichtlich ihres Durchlassverlusts und/oder Schaltverlusts als die mindestens eine Verlustleistung und somit hinsichtlich eines Betriebsparameters, sind aber ansonsten gleichartig.

Dabei weist das mindestens eine erste Halbleiterelement einen Durchlassverlust mit einem ersten Wert auf, der höher als ein zweiter Wert eines Durchlassverlusts des mindestens einen zweiten Halbleiterelements ist, das gleichartig wie das erste Halbleiterelement ausgebildet ist, wobei dann das mindestens eine erste Halbleiterelement einen Schaltverlust mit einem ersten Wert aufweist, der geringer als ein zweiter Wert eines Schaltverlusts des mindestens einen zweiten Halbleiterelements ist.

Entsprechend weist das mindestens eine zweite Halbleiterelement einen Durchlassverlust mit dem zweiten Wert auf, der geringer als der erste Wert des Durchlassverlusts des mindestens einen ersten Halbleiterelements ist, wobei das mindestens eine zweite Halbleiterelement, das gleichartig wie das erste ausgebildet ist, einen Schaltverlust mit dem zweiten Wert aufweist, der höher als der erste Wert des Schaltverlusts des mindestens einen ersten Halbleiterelements ist.

Außerdem ist es möglich, dass zwei gleichartige Halbleiterelemente, deren Werte für die mindestens eine Charakteristik und/oder Verlustleistung sich voneinander unterscheiden, direkt nebeneinander geschaltet sind.

Die mindestens zwei Halbleiterelemente sind bspw. als Bipolartransistoren mit integrierten Gate-Elektroden (IGBTs) ausgebildet.

Alternativ oder ergänzend sind die mindestens zwei Halbleiterelemente bspw. als Metall-Oxid-Halbleiter-Feldeffekttransistoren (MOSFETs) ausgebildet.

Somit ist es möglich, dass zwei parallel geschaltete Halbleiterelemente als Bipolartransistoren mit integrierten Gate-Elektroden und somit gleichartig ausgebildet sind, die mindestens eine unterschiedliche Charakteristik bzw. Verlustleistung, d. h. Durchlassverlust und/oder Schaltverlust, aufweisen. Außerdem ist es möglich, dass zwei parallel geschaltete Halbleiterelemente als Metall-Oxid-Halbleiter-Feldeffekttransistoren und somit gleichartig ausgebildet sind, die mindestens eine unterschiedliche Charakteristik bzw. Verlustleistung, d. h. Durchlassverlust und/oder Schaltverlust, aufweisen.

Weiterhin ist es möglich, dass mindestens zwei Halbleiterelemente, üblicherweise Bipolartransistoren mit integrierten Gate-Elektroden (IGBT) oder ggf. Metall-Oxid-Halbleiter-Feldeffekttransistoren, mit einer Diode als ein weiteres Halbleiterelement in Reihe geschaltet sind, wobei diese Diode dem mindestens einen Halbleiterelement vorgeschaltet oder nachgeschaltet ist. Je nach Definition ist mindestens ein Halbleiterelement als elektronisches Bauteil aus Halbleitermaterial ausgebildet, wobei ein jeweiliges Halbleiterelement mindestens ein elektronisches Bauteil, d. h. ein elektronisches Bauteil oder mehrere elektronische Bauteile, aufweist. Ein Halbleiterelement ist üblicherweise als kleinstmögliches, kompaktes elektronisches Bauteil, bspw. als MOSFET, IGBT, Transistor oder Diode, ausgebildet und/oder zu bezeichnen.

Die mindestens zwei gleichartigen Halbleiterelemente weisen in Ausgestaltung Silizium, bspw. Siliziumcarbid (SiC), auf. In weiterer Ausgestaltung weisen die mindestens zwei Halbleiterelemente Galliumnitrit auf.

Für das mindestens eine erste Halbleiterelement ist in Ausgestaltung eine erste Kennlinie vorgesehen, die bspw. als Trade-Off-Kennlinie ausgebildet und/oder zu bezeichnen ist sowie einen Zusammenhang des Schaltverlusts und des Durchlassverlusts bzw. eine wechselseitige Abhängigkeit des Schaltverlusts und des Durchlassverlusts des mindestens einen ersten Halbleiterelements darstellt und/oder beschreibt. Für das mindestens eine zweite Halbleiterelement ist in Ausgestaltung eine zweite Kennlinie vorgesehen, die einen Zusammenhang des Schaltverlusts und des Durchlassverlusts bzw. eine wechselseitige Abhängigkeit des Schaltverlusts und des Durchlassverlusts des mindestens einen zweiten Halbleiterelements darstellt und/oder beschreibt. Dabei sind diese beiden Kennlinien für die mindestens zwei besagten und parallel geschalteten Halbleiterelemente bezüglich des Zusammenhangs zwischen Durchlassverlust und Schaltverlust zueinander verschoben.

Die Schaltungsanordnung ist in Ausgestaltung als Halbbrücke und/oder für ein Gerät zum Steuern eines Fahrzeugs, bspw. eines Kraftfahrzeugs, ausgebildet.

Durch Vorsehen mindestens zwei zueinander parallel geschalteter, gleichartiger Halbleiterelemente mit mindestens einer unterschiedlichen Verlustleistung kann eine hybride Schaltungsanordnung für ein elektronisches Leistungsmodul bereitgestellt werden. Diese Schaltungsanordnung bzw. ein entsprechendes Leistungsmodul ist in Ausgestaltung an unterschiedlichen Stellen eines Fahrzeugs einsetzbar.

Dies ist bspw. in einem Spannungsbereich von 12 Volt für eine Lenkung oder eine Getriebesteuerung der Fall. Allerdings sind auch Anwendungen in einem Hochspannungsbereich, bspw. in einem Hybridelektrofahrzeug (HEV) oder Plug-In-Hybridelektrokraftfahrzeug (PHEV), möglich. Die Schaltungsanordnung mit den sich hinsichtlich der Verlustleistung voneinander unterscheidenden parallel geschalteten Halbleiterelementen ist bspw. in einem Traktionspulswechselrichter, in einem elektrischen Klimakompressor (eKK) oder in einem Gleichstrom-bzw. DC/DC-Wandler einsetzbar.

Weiterhin ist es vorgesehen, für die Schaltungsanordnung eine Kombination aus gleichartigen zueinander parallel geschalteten Halbleiterelementen zu verwenden, die bspw. als schnell schaltende MOSFETs auf Basis von Silizium, bspw. Siliziumcarbid (SiC) oder bspw. als IGBTs ausgebildet sind, die für Durchlassverluste hoch optimiert sind. Hierbei ist es möglich, für die zueinander parallel geschalteten Halbleiterelemente unterschiedliche, d. h. in der Regel zueinander verschobene Trade-Off-Kennlinien sowie Trade-Off-Punkte zu berücksichtigen. Weiterhin ist eine Kombination von IGBTs mit unterschiedlichen Verlustleistungen denkbar. Die Halbleiterelemente sind in Ausgestaltung auch mit Dioden in Reihe geschaltet, die jedoch bei einer Verwendung von MOSFETs eventuell nicht erforderlich sind. Somit ist es möglich, dass zwei zueinander parallel geschaltete Halbleiterelemente lediglich MOSFETs umfassen. Alternativ sind zwei zueinander parallel geschaltete Halbleiterelemente als IGBTs mit vorgeschalteten oder nachgeschalteten Dioden ausgebildet. Weiterhin ist es möglich, einen Trade-Off aus einem Wirkungsgrad und einer maximalen Ausgangsleistung optimal einzustellen.

Die Schaltungsanordnung mit den mindestens zwei zueinander parallel geschalteten, gleichartigen Halbleiterelementen ist für eine Vorrichtung in einem Fahrzeug verwendbar. Dabei ist vorgesehen, dass bei einer Einstellung unterschiedlicher Charakteristiken dieser gleichartigen Halbleiterelemente bei einem Fahrzyklus unter Last bspw. deren Verlustleistungen sowie ggf. deren Chipflächen variiert werden, wobei für die parallel geschalteten gleichartigen Halbleiterelemente eine gemeinsame minimale Verlustleistung und somit ein optimierter Wirkungsgrad einstellbar ist.

In einer weiteren Ausgestaltung sind mit einer Kombination eines ersten Halbleiterelements, das als IGBT mit ggf. in Reihe geschalteter Diode ausgebildet ist, sowie eines zweiten dazu parallel geschalteten Halbleiterelements, das als MOSFET ausgebildet ist, hohe Schaltgeschwindigkeiten und gute Durchlasseigenschaften über den MOSFET im Niederlastbereich und über den IGBT im Hochlastbereich erreichbar. Außerdem ist im Normalbetrieb der Schaltungsanordnung ein optimierter Wirkungsgrad mit einer verbesserten Überlastfähigkeit bereitstellbar. Für eine erforderliche Fläche der Schaltungsanordnung sind Kosten und ein Bauraum reduzierbar.

Insgesamt weist eine mögliche Ausführungsform der vorgestellten Schaltungsanordnung mindestens zwei zueinander parallel geschaltete Halbleiterelemente mit unterschiedlichen Charakteristiken und somit mit mindestens einer verschiedenartigen Verlustleistung auf. Dies ist bspw. dann der Fall, wenn diese mindestens zwei Halbleiterelemente eine verschiedenartige Architektur aufweisen, aus unterschiedlichen Materialien hergestellt sind, von unterschiedlichen Wafern bzw. scheibenförmigen Rohlingen für Halbleitermaterial stammen, und/oder von unterschiedlichen Herstellern hergestellt worden sind. Dabei ist es möglich, dass die mindestens zwei zueinander parallel geschalteten Halbleiterelemente einerseits ein bipolares Verhalten (IGBT) und andererseits ein ohm'sches und/oder unipolares Verhalten (MOSFET) aufweisen. Die mindestens zwei sich voneinander hinsichtlich ihrer Charakteristik unterscheidenden Halbleiterelemente umfassen bspw. Silizium und/oder Galliumnitrit.

Weitere Vorteile und Ausgestaltungen der Erfindung ergeben sich aus der Beschreibung und der beiliegenden Zeichnung.

Es versteht sich, dass die voranstehend genannten und die nachstehend noch zu erläuternden Merkmale nicht nur in der jeweils angegebenen Kombination sowie auch in anderen Kombinationen oder in Alleinstellung verwendbar sind, ohne den Rahmen der vorliegenden Erfindung zu verlassen.

Die Erfindung ist anhand von Ausführungsformen in der Zeichnung schematisch dargestellt und wird unter Bezugnahme auf die Zeichnung schematisch und ausführlich beschrieben.
Figur 1 zeigt eine erste Ausführungsform der erfindungsgemäßen Schaltungsanordnung in zwei unterschiedlichen schematischen Darstellungen.
Figur 2 zeigt eine zweite Ausführungsform der erfindungsgemäßen Schaltungsanordnung in zwei unterschiedlichen schematischen Darstellungen.
Figur 3 zeigt ein Diagramm mit Kennlinien, die für mindestens eine Ausführungsform der Schaltungsanordnung berücksichtigbar sind.

Die Figuren werden zusammenhängend und übergreifend beschrieben, gleichen Komponenten sind dieselben Bezugsziffern zugeordnet.

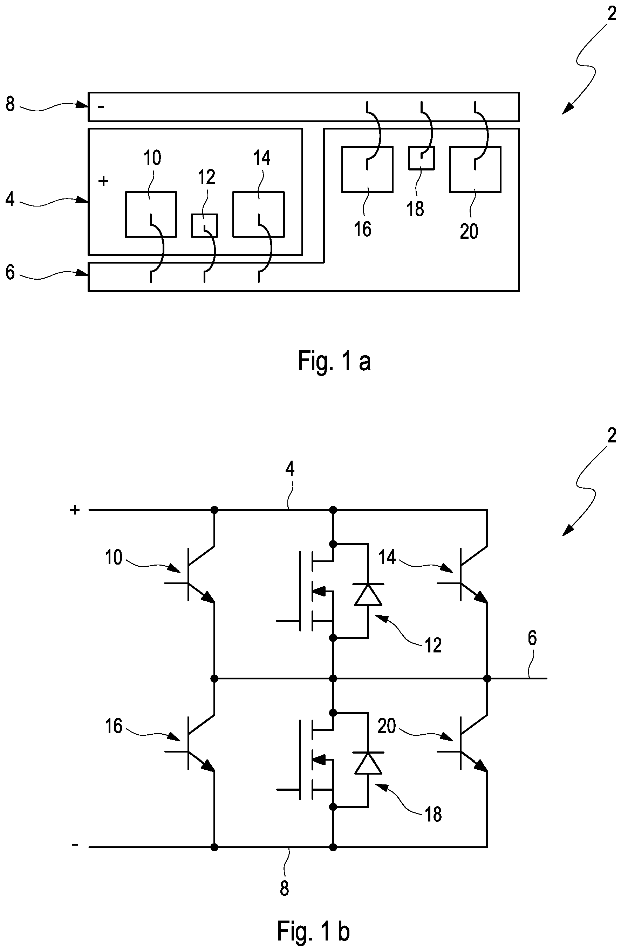

Figur 1a zeigt eine erste schematische Darstellung der ersten Ausführungsform der erfindungsgemäßen Schaltungsanordnung 2 und Figur 1b eine zweite schematische Darstellung dieser ersten Ausführungsform der Schaltungsanordnung 2. Dabei ist die Schaltungsanordnung 2 in eine positive Stromschiene bzw. einen Pluspol 4, eine Phase 6 sowie eine negative Stromschiene bzw. einen Minuspol 8 unterteilt, wobei die Phase 6 zwischen dem Pluspol 4 und dem Minuspol 8 angeordnet ist. Mit dem Pluspol 4 sind drei zueinander parallel geschaltete Halbleiterelemente 10, 12, 14 verbunden. Diese drei zueinander parallel geschalteten Halbleiterelemente 10, 12, 14 sind mit drei weiteren zueinander parallel geschalteten Halbleiterelementen 16, 18, 20 in Reihe geschaltet.

Hierbei ist ein erstes Halbleiterelement 10 als IGBT, ein zweites Halbleiterelement 12 als MOSFET und ein drittes Halbleiterelement 14 als IGBT ausgebildet. Dabei unterscheidet sich das zweite Halbleiterelement 12 hinsichtlich mindestens einer Verlustleistung, d. h. hinsichtlich eines Durchlassverlusts und/oder Schaltverlusts, von den beiden anderen Halbleiterelementen 10, 14, zu denen dieses zweite Halbleiterelement 12 parallel geschaltet ist. Außerdem unterscheiden sich das erste und das dritte Halbleiterelement 10, 14, die als IGBTs und somit als gleichartige Halbleiterelemente 10, 14 ausgebildet sind, ebenfalls hinsichtlich mindestens einer Verlustleistung.

Außerdem ist ein viertes Halbleiterelement 16 als IGBT, ein fünftes Halbleiterelement 18 als MOSFET und ein sechstes Halbleiterelement 20 als IGBT ausgebildet. In diesem Fall unterscheidet sich auch das fünfte Halbleiterelement 18 hinsichtlich mindestens einer Verlustleistung, d. h. hinsichtlich des Durchlassverlusts und/oder des Schaltverlusts, von den beiden anderen dazu parallel geschalteten Halbleiterelementen 16, 18.

Außerdem ist hier vorgesehen, dass sich das vierte und sechste Halbleiterelement 16, 20, die beide als IGBTs und somit als gleichartige Halbleiterelemente 16, 20 ausgebildet sind, hinsichtlich mindestens einer Verlustleistung unterscheiden.

Weiterhin ist vorgesehen, dass das erste Halbleiterelement 10 mit dem vierten Halbleiterelement 16 in Reihe geschaltet ist. Das zweite Halbleiterelement 12 und das fünfte Halbleiterelement 18 sind ebenfalls in Reihe geschaltet. Ferner sind das dritte Halbleiterelement 14 und das sechste Halbleiterelement 20 in Reihe geschaltet.

Insgesamt sind alle vier als IGBTs ausgebildeten Halbleiterelemente 10, 14, 16, 20 hinsichtlich ihrer Architektur, ihres Typs und/oder schaltungstechnisch gleichartig ausgebildet. Dabei ist vorgesehen, dass sich auch das erste Halbleiterelement 10 von dem sechsten Halbleiterelement 20 und das dritte Halbleiterelement 14 von dem vierten Halbleiterelement 16, die jeweils parallel geschaltet sind, hinsichtlich mindestens einer Verlustleistung unterscheidet.

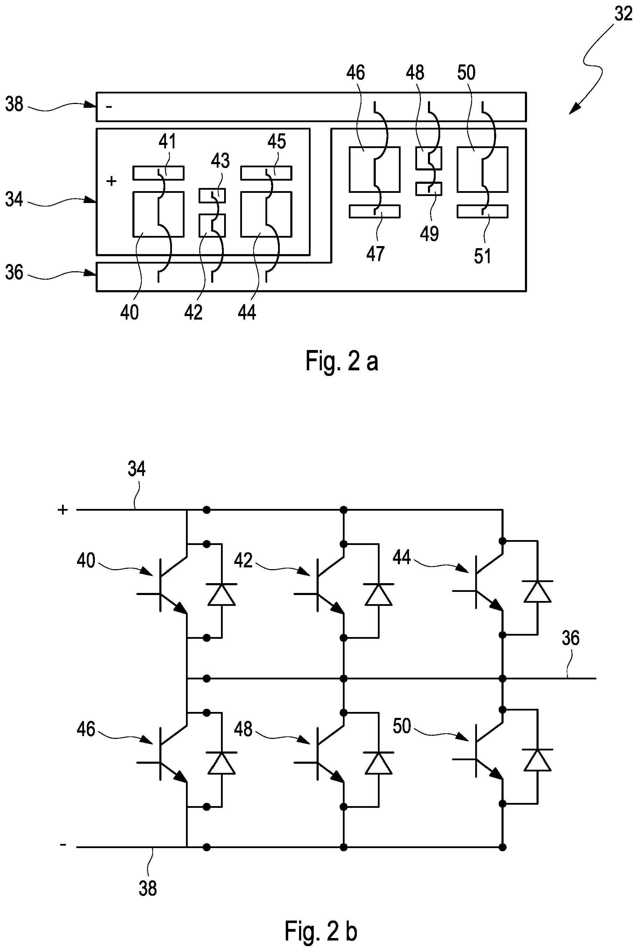

Figur 2a zeigt eine erste schematische Darstellung und Figur 2b eine zweite schematische Darstellung der zweiten Ausführungsform der erfindungsgemäßen Schaltungsanordnung. Dabei ist die Schaltungsanordnung 32 in eine positive Stromschiene bzw. einen Pluspol 34, eine Phase 36 sowie eine negative Stromschiene bzw. einen Minuspol 38 unterteilt, wobei die Phase 36 zwischen dem Pluspol 34 und dem Minuspol 38 angeordnet ist. Mit dem Pluspol 34 sind drei zueinander parallel geschaltete Halbleiterelemente 40, 42, 44 verbunden.

Dabei ist ein erstes Halbleiterelement 40 als ein IGBT mit einer ersten Charakteristik, ein zweites Halbleiterelement 42 als IGBT mit einer zweiten Charakteristik und ein drittes Halbleiterelement 44 als IGBT mit derselben ersten Charakteristik wie das erste Halbleiterelement 40 ausgebildet. Hierbei unterscheidet sich das zweite Halbleiterelement 42 hinsichtlich mindestens einer Verlustleistung, d. h. hinsichtlich eines Durchlassverlusts und/oder Schaltverlusts, von jeweils einem der beiden anderen Halbleiterelemente 40, 44.

Dabei ist es hier möglich, dass der Durchlassverlust des zweiten Halbleiterelements 42 größer als ein jeweiliger Durchlassverlust eines der beiden anderen Halbleiterelemente 40, 44 ist, wohingegen der Schaltverlust des ersten Halbleiterelements 40 und des dritten Halbleiterelements 44 jeweils größer als der Schaltverlust des zweiten Halbleiterelements 42 ist.

Außerdem ist jedes der drei Halbleiterelemente 40, 42, 44 mit einer Diode 41, 43, 45 in Reihe geschaltet. Dabei ist es möglich, dass diese drei Dioden 41, 43, 45 dieselbe Charakteristik aufweisen. Es ist jedoch auch möglich, dass die Diode 43, die mit dem zweiten Halbleiterelement 42 in Reihe geschaltet ist, eine andere Charakteristik als jeweils eine der beiden Dioden 41, 45 aufweist, die mit den beiden anderen Halbleiterelementen 40, 44 in Reihe geschaltet ist, die sich hinsichtlich ihrer Charakteristik von dem zweiten Halbleiterelement 42 jeweils unterscheiden.

Außerdem umfasst diese Schaltungsanordnung 32 ein viertes Halbleiterelement 46, ein fünftes Halbleiterelement 48 sowie ein sechstes Halbleiterelement 50. Dabei ist das vierte Halbleiterelement 46 auch als IGBT mit der ersten Charakteristik, das fünfte Halbleiterelement 48 als IGBT mit der zweiten Charakteristik und das sechste Halbleiterelement 50 als IGBT mit der ersten Charakteristik ausgebildet.

Somit unterscheidet sich das fünfte Halbleiterelement 48 mit der zweiten Charakteristik hinsichtlich mindestens einer Verlustleistung, d. h. hinsichtlich des Schaltverlusts und/oder des Durchlassverlusts, von den beiden anderen dazu parallel geschalteten Halbleiterelementen 46, 50, die die erste Charakteristik und somit die mindestens eine erste Verlustleistung aufweisen.

Das vierte Halbleiterelement 46 ist weiterhin mit einer Diode 47 in Reihe geschaltet. Das fünfte Halbleiterelement 48 ist mit einer Diode 49 in Reihe geschaltet. Außerdem ist das sechste Halbleiterelement 50 mit einer Diode 51 in Reihe geschaltet. Dabei weisen die beiden Dioden 47, 51, die mit jeweils einem Halbleiterelement 46, 50 in Reihe geschaltet sind, eine Charakteristik auf, die sich von der Charakteristik der Diode 49 unterscheidet, die mit dem fünften Haltleitermodul 48 in Reihe geschaltet ist.

Außerdem ist innerhalb dieser Schaltungsanordnung 32 vorgesehen, dass das erste Halbleiterelement 40 und das vierte Halbleiterelement 46, die beide dieselbe erste Charakteristik aufweisen, in Reihe geschaltet sind. Außerdem sind das zweite Halbleiterelement 42 und das fünfte Halbleiterelement 48, die dieselbe zweite Charakteristik aufweisen, hier in Reihe geschaltet. Das dritte Halbleiterelement 44 und das sechste Halbleiterelement 50, die dieselbe erste Charakteristik aufweisen, sind hier ebenfalls in Reihe geschaltet.

Bei allen möglichen Ausführungsformen von erfindungsgemäßen Schaltungsanordnungen 2, 32 ist vorgesehen, dass sich mindestens zwei zueinander parallel geschaltete gleichartige Halbleiterelemente 10, 14, 16, 20, 40, 42, 44, 46, 48, 50 hinsichtlich ihrer Charakteristik, hier hinsichtlich mindestens einer Verlustleistung voneinander unterscheiden. Dies ist, wie bei der ersten Ausführungsform der Schaltungsanordnung 2 dann der Fall, wenn die zwei zueinander parallel geschalteten, gleichartigen Halbleiterelemente 10, 14, 16, 20 zwar dieselbe Architektur aufweisen und als IGBTs ausgebildet sind, aber dennoch unterschiedliche Charakteristiken aufweisen.

Es ist jedoch auch möglich, dass zwei zueinander parallel angeordnete Halbleiterelemente 40, 42, 44, 46, 48, 50, wie bspw. im Fall der zweiten Schaltungsanordnung 32, zwar dieselbe Architektur aufweisen, und hier jeweils als IGBTs ausgebildet sind, sich jedoch hinsichtlich mindestens einer Verlustleistung, d. h. hinsichtlich des Schaltverlusts und/oder Durchlassverlusts voneinander unterscheiden. Dies ist bereits dann der Fall, wenn sich die beiden zueinander parallel angeordneten Halbleiterelemente 40, 42, 44, 46, 48, 50 lediglich hinsichtlich einer Verlustleistung, d. h. lediglich hinsichtlich des Schaltverlusts oder des Durchlassverlusts voneinander unterscheiden, jedoch eine zweite Verlustleistung mit jeweils demselben Wert aufweisen.

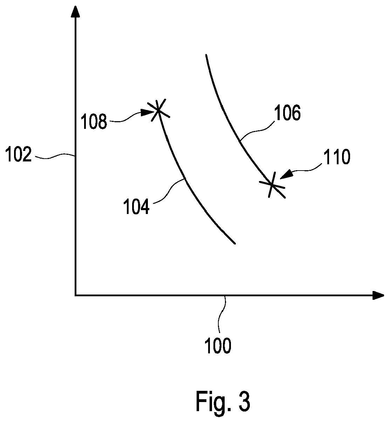

Diesbezüglich wird auch auf das Diagramm aus Figur 3 verwiesen, bei dem entlang einer Abszisse 100 ein Durchlassverlust (V_{ce}) als erste Verlustleistung aufgetragen ist. Entlang einer Ordinate 102 dieses Diagramms aus Figur 3 ist ein Schaltverlust (E_{off}) als zweite Verlustleistung aufgetragen.

In dem Diagramm aus Figur 3 ist eine erste Kennlinie 104 für ein erstes Halbleiterelement und eine zweite Kennlinie 106 für ein zweites Halbleiterelement eingetragen. Dabei ist hier vorgesehen, dass die beiden Halbleiterelemente dieselbe Architektur aufweisen und hier bspw. als IGBTs oder alternativ als MOSFETs und demnach als gleichartige Halbleiterelemente ausgebildet sind. Dabei zeigen die beiden Kennlinien 104, 106, die auch als Trade-Off-Kennlinien bezeichnet werden, einen jeweiligen Zusammenhang zwischen Durchlassverlust und Schaltverlust eines jeweiligen Halbleiterelements. Da die beiden Kennlinien 104, 106 zueinander parallel verschoben sind, unterscheiden sich die beiden Halbleiterelemente hier hinsichtlich ihres Durchlassverlusts sowie ihres Schaltverlusts voneinander.

Bei einer Ausführungsform der Schaltungsanordnung sind diese beiden gleichartigen Halbleiterelemente zueinander parallel geschaltet. Außerdem ist für das erste Halbleiterelement entlang der ersten Kennlinie 104 ein erster Trade-Off-Punkt 108 und für das zweite Halbleiterelemente entlang der zweiten Kennlinie 106 ein zweiter Trade-Off-Punkt 110 eingestellt. Demnach weist das erste Halbleiterelement einen höheren Durchlassverlust als das zweite Halbleiterelement auf, wohingegen das zweite Halbleiterelement einen höheren Schaltverlust als das erste Halbleiterelement aufweist.

In einer weiteren Ausgestaltung der Schaltungsanordnung ist für beide zueinander parallel geschalteten, gleichartigen Halbleiterelemente dieselbe Trade-Off-Kennlinie vorgesehen. In diesem Fall ist für das erste Halbleiterelement ein erster Trade-Off-Punkt und für das zweite Halbleiterelement ein zweiter Trade-Off-Punkt vorgesehen, wobei sich diese beiden gleichartigen Halbleiterelemente sowohl hinsichtlich des Durchlassverlustes als auch hinsichtlich des Schaltverlustes voneinander unterscheiden.

## Patentansprüche

1. Schaltungsanordnung für ein elektronisches Gerät, die mindestens zwei zueinander parallel geschaltete, gleichartige Halbleiterelemente (10, 14, 16, 20, 40, 42, 44, 46, 48, 50) aufweist, wobei mindestens ein erstes Halbleiterelement (10, 14, 16, 20, 40, 42, 44, 46, 48, 50) eine erste Charakteristik und mindestens ein zweites Halbleiterelement (10, 14, 16, 20, 40, 42, 44, 46, 48, 50) eine zweite Charakteristik aufweist, wobei jede der beiden Charakteristiken durch mindestens eine Verlustleistung definiert ist, wobei die mindestens eine Verlustleistung des mindestens einen ersten Halbleiterelements (10, 14, 16, 20, 40, 42, 44, 46, 48, 50) einen ersten Wert aufweist, wobei die mindestens eine Verlustleistung des mindestens einen zweiten Halbleiterelements (10, 14, 16, 20, 40, 42, 44, 46, 48, 50) einen zweiten Wert aufweist, wobei die beiden Werte der mindestens einen Verlustleistung unterschiedlich sind,
**dadurch gekennzeichnet,**
**dass** die mindestens zwei gleichartigen Halbleiterelemente dieselbe Kennlinie aufweisen, wobei die mindestens zwei Halbleiterelemente an unterschiedlichen Punkten entlang dieser Kennlinie betrieben werden, wobei eine erste Verlustleistung als Durchlassverlust und eine zweite Verlustleistung als Schaltverlust definiert ist.

2. Schaltungsanordnung nach Anspruch 1, bei der das mindestens eine erste Halbleiterelement (10, 14, 16, 20, 40, 42, 44, 46, 48, 50) einen Durchlassverlust mit einem ersten Wert aufweist, der höher als ein zweiter Wert eines Durchlassverlusts des mindestens einen zweiten Halbleiterelements (10, 14, 16, 20, 40, 42, 44, 46, 48, 50) ist, und wobei das mindestens eine erste Halbleiterelement (10, 14, 16, 20, 40, 42, 44, 46, 48, 50) einen Schaltverlust mit einem ersten Wert aufweist, der geringer als ein zweiter Wert eines Schaltverlusts des mindestens einen zweiten Halbleiterelements (10, 14, 16, 20, 40, 42, 44, 46, 48, 50) ist.

3. Schaltungsanordnung nach Anspruch 1 oder 2, bei der zwei gleichartige Halbleiterelemente (10, 14, 16, 20, 40, 42, 44, 46, 48, 50), deren Werte für die mindestens eine Charakteristik sich voneinander unterscheiden, direkt nebeneinander geschaltet sind.

4. Schaltungsanordnung nach einem der voranstehenden Ansprüche, bei der die mindestens zwei gleichartigen Halbleiterelemente (10, 14, 16, 20, 40, 42, 44, 46, 48, 50) als Bipolartransistoren mit integrierten Gate-Elektroden ausgebildet sind.

5. Schaltungsanordnung nach einem der voranstehenden Ansprüche, bei der die mindestens zwei gleichartigen Halbleiterelemente (10, 14, 16, 20, 40, 42, 44, 46, 48, 50) als Metall-Oxid-Halbleiter-Feldeffekttransistoren ausgebildet sind.

6. Schaltungsanordnung nach einem der voranstehenden Ansprüche, bei der mindestens ein Halbleiterelement (10, 14, 16, 20, 40, 42, 44, 46, 48, 50) der mindestens zwei gleichartigen Halbleiterelemente (10, 14, 16, 20, 40, 42, 44, 46, 48, 50) mit einer Diode (41, 43, 45, 47, 49, 51) in Reihe geschaltet ist.

7. Schaltungsanordnung nach einem der voranstehenden Ansprüche, bei der die mindestens zwei Halbleiterelemente (10, 14, 16, 20, 40, 42, 44, 46, 48, 50) Silizium aufweisen.

8. Schaltungsanordnung nach einem der voranstehenden Ansprüche, bei der die mindestens zwei gleichartigen Halbleiterelemente Galliumnitrit aufweisen.

9. Schaltungsanordnung nach einem der voranstehenden Ansprüche, die als Halbbrücke ausgebildet ist.

## Claims

1. Circuit arrangement for an electronic device, which has at least two semiconductor elements (10, 14, 16, 20, 40, 42, 44, 46, 48, 50) of the same type and connected in parallel with one another, wherein at least one first semiconductor element (10, 14, 16, 20, 40, 42, 44, 46, 48, 50) has a first characteristic and at least one second semiconductor element (10, 14, 16, 20, 40, 42, 44, 46, 48, 50) has a second characteristic, wherein each of the two characteristics is defined by at least one power loss, wherein the at least one power loss of the at least one first semiconductor element (10, 14, 16, 20, 40, 42, 44, 46, 48, 50) has a first value, wherein the at least one power loss of the at least one second semiconductor element (10, 14, 16, 20, 40, 42, 44, 46, 48, 50) has a second value, wherein the two values of the at least one power loss are different,
**characterised in that**
the at least two semiconductor elements of the same type have the same characteristic curve, wherein the at least two semiconductor elements are operated at different points along said characteristic curve, wherein a first power loss is defined as a conduction loss and a second power loss is defined as a switching loss.

2. Circuit arrangement according to claim 1, wherein the at least one first semiconductor element (10, 14, 16, 20, 40, 42, 44, 46, 48, 50) has a conduction loss with a first value which is higher than a second value of a conduction loss of the at least one second semiconductor element (10, 14, 16, 20, 40, 42, 44, 46, 48, 50), and wherein the at least one first semiconductor element (10, 14, 16, 20, 40, 42, 44, 46, 48, 50) has a switching loss with a first value which is lower than a second value of a switching loss of the at least one second semiconductor element (10, 14, 16, 20, 40, 42, 44, 46, 48, 50).

3. Circuit arrangement according to claim 1 or 2, wherein two semiconductor elements (10, 14, 16, 20, 40, 42, 44, 46, 48, 50) of the same type, whose values for the at least one characteristic differ from one another, are switched directly next to one another.

4. Circuit arrangement according to any of the preceding claims, wherein the at least two semiconductor elements (10, 14, 16, 20, 40, 42, 44, 46, 48, 50) of the same type are configured as bipolar transistors with integrated gate electrodes.

5. Circuit arrangement according to any of the preceding claims, wherein the at least two semiconductor elements (10, 14, 16, 20, 40, 42, 44, 46, 48, 50) of the same type are designed as metal oxide semiconductor field effect transistors.

6. Circuit arrangement according to any of the preceding claims, wherein at least one semiconductor element (10, 14, 16, 20, 40, 42, 44, 46, 48, 50) of the at least two semiconductor elements (10, 14, 16, 20, 40, 42, 44, 46, 48, 50) of the same type is connected in series with a diode (41, 43, 45, 47, 49, 51).

7. Circuit arrangement according to any of the preceding claims, wherein the at least two semiconductor elements (10, 14, 16, 20, 40, 42, 44, 46, 48, 50) include silicon.

8. Circuit arrangement according to any of the preceding claims, wherein the at least two semiconductor elements of the same type include gallium nitride.

9. Circuit arrangement according to any of the preceding claims, which is configured as a half bridge.

## Revendications

1. Dispositif de commutation pour un appareil électronique, qui présente au moins deux éléments semi-conducteurs similaires (10, 14, 16, 20, 40, 42, 44, 46, 48, 50) montés en parallèle l'un à l'autre, dans lequel au moins un premier élément semi-conducteur (10, 14, 16, 20, 40, 42, 44, 46, 48, 50) présente une première caractéristique et au moins un second élément semi-conducteur (10, 14, 16, 20, 40, 42, 44, 46, 48, 50) présente une seconde caractéristique, dans lequel chacune des deux caractéristiques est définie par au moins une puissance dissipée, dans lequel la au moins une puissance dissipée du au moins un premier élément semi-conducteur (10, 14, 16, 20, 40, 42, 44, 46, 48, 50) présente une première valeur, dans lequel la au moins une puissance dissipée du au moins un second élément semi-conducteur (10, 14, 16, 20, 40, 42, 44, 46, 48, 50) présente une seconde valeur, dans lequel les deux valeurs de la au moins une puissance dissipée sont différentes, **caractérisé en ce que** les au moins deux éléments semi-conducteurs similaires présentent la même courbe caractéristique, dans lequel les au moins deux éléments semi-conducteurs fonctionnent à différents points le long de cette courbe caractéristique, dans lequel une première puissance dissipée est définie comme perte à l'état passant et une seconde puissance dissipée comme perte par commutation.

2. Dispositif de commutation selon la revendication 1, selon lequel le au moins un premier élément semi-conducteur (10, 14, 16, 20, 40, 42, 44, 46, 48, 50) présente une perte à l'état passant avec une première valeur, qui est plus élevée qu'une seconde valeur d'une perte à l'état passant du au moins un second élément semi-conducteur (10, 14, 16, 20, 40, 42, 44, 46, 48, 50), et dans lequel le au moins un premier élément semi-conducteur (10, 14, 16, 20, 40, 42, 44, 46, 48, 50) présente une perte par commutation avec une première valeur, qui est plus faible qu'une seconde valeur d'une perte par commutation du au moins un second élément semi-conducteur (10, 14, 16, 20, 40, 42, 44, 46, 48, 50).

3. Dispositif de commutation selon la revendication 1 ou 2, selon lequel deux éléments semi-conducteurs similaires (10, 14, 16, 20, 40, 42, 44, 46, 48, 50), dont les valeurs pour la au moins une caractéristique diffèrent l'une de l'autre, sont montés directement l'un à côté de l'autre.

4. Dispositif de commutation selon l'une quelconque des revendications précédentes, selon lequel les au moins deux éléments semi-conducteurs similaires (10, 14, 16, 20, 40, 42, 44, 46, 48, 50) sont configurés comme des transistors bipolaires avec des électrodes de grille intégrées.

5. Dispositif de commutation selon l'une quelconque des revendications précédentes, selon lequel les au moins deux éléments semi-conducteurs similaires (10, 14, 16, 20, 40, 42, 44, 46, 48, 50) sont configurés comme des transistors métal-oxyde-semi-conducteur à effet de champ.

6. Dispositif de commutation selon l'une quelconque des revendications précédentes, selon lequel au moins un élément semi-conducteur (10, 14, 16, 20, 40, 42, 44, 46, 48, 50) des au moins deux éléments semi-conducteurs similaires (10, 14, 16, 20, 40, 42, 44, 46, 48, 50) est monté en série avec une diode (41, 43, 45, 47, 49, 51).

7. Dispositif de commutation selon l'une quelconque des revendications précédentes, selon lequel les au moins deux éléments semi-conducteurs (10, 14, 16, 20, 40, 42, 44, 46, 48, 50) présentent du silicium.

8. Dispositif de commutation selon l'une quelconque des revendications précédentes, selon lequel les au moins deux éléments semi-conducteurs similaires présentent du nitrite de gallium.

9. Dispositif de commutation selon l'une quelconque des revendications précédentes, qui est configuré en tant que demi-pont.
